# EUROPEAN PATENT SPECIFICATION

(11) **EP 0 361 900 B1**
(45) Date of publication and mention of the grant of the patent: **16.03.1994**
(21) Application number: 89309843.4
(22) Date of filing: 27.09.1989
(51) Int. Cl.: H01L 29/92

(54) **Semiconductor device having a built-in capacitor and manufacturing method thereof**
Halbleiteranordnung mit eingebautem Kondensator und deren Herstellungsmethode
Dispositif semi-conducteur avec un condensateur incorporé et sa méthode de fabrication

(30) Priority: 30.09.1988 JP 248852/88
(43) Date of publication of application: 04.04.1990
(73) Proprietor: FUJITSU LIMITED, Kawasaki-shi, Kanagawa 211 (JP)
(72) Inventor: Kawai, Takahisa, Kawasaki-shi Kanagawa, 211 (JP)
(74) Representative: Stebbing, Timothy Charles

(56) References cited:
- PATENT ABSTRACTS OF JAPAN vol. 11, no. 11 (E-470)(2458) 13 January 1987, & JP-A-61 187278
- PATENT ABSTRACTS OF JAPAN vol. 1, no. 38 (E-76) 19 April 1977, & JP-A-51 135480
- PATENT ABSTRACTS OF JAPAN vol. 1, no. 20 (E-76) 24 March 1977, & JP-A-51 118971

## Description

### BACKGROUND OF THE INVENTION

The present invention generally relates to semiconductor devices and more particularly to a semiconductor device having a built-in capacitor and a manufacturing method thereof.

A so-called microwave monolithic integrated circuit (MMIC) is a semiconductor device designed for use in the ultra-high frequency (UHF) range or in the super-high frequency (SHF) range. Such an integrated circuit for microwave application often uses a shunt capacitor having an electrode connected to the ground.

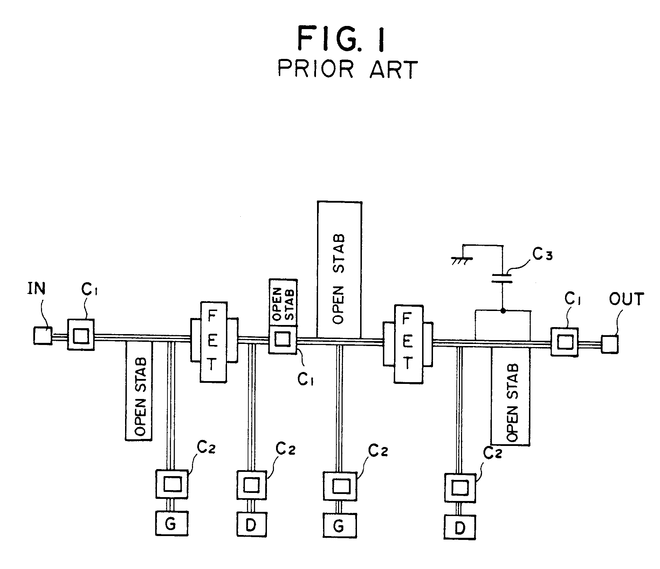

FIG.1 shows a typical MMIC device comprising a pair of FETs forming a two-stage amplifier circuit. In this device, a plurality of capacitors C₁ are interposed in a signal path extending from an input terminal IN to an output terminal OUT and there is further provided a shunt capacitor C₂ in a vicinity of a gate biasing terminal G or a drain biasing terminal D for removing unwanted high frequency components. Further, there is another shunt capacitor C₃ connected to the signal path for achieving impedance matching.

Conventionally, impedance matching of signal path in the MMIC is achieved by providing an open stab acting as a capacitance of which size is adjusted so as to achieve a proper impedance matching. However, such an open stab occupies a large area and needs trimming to establish a desired impedance. It is preferred to achieve such an impedance matching by using the shunt capacitor C₃ designed to have a proper capacitance value. The present invention is mainly related to such a shunt capacitor having one electrode connected to the ground or constant voltage source for bypassing the high frequency component to the ground or used for impedance matching.

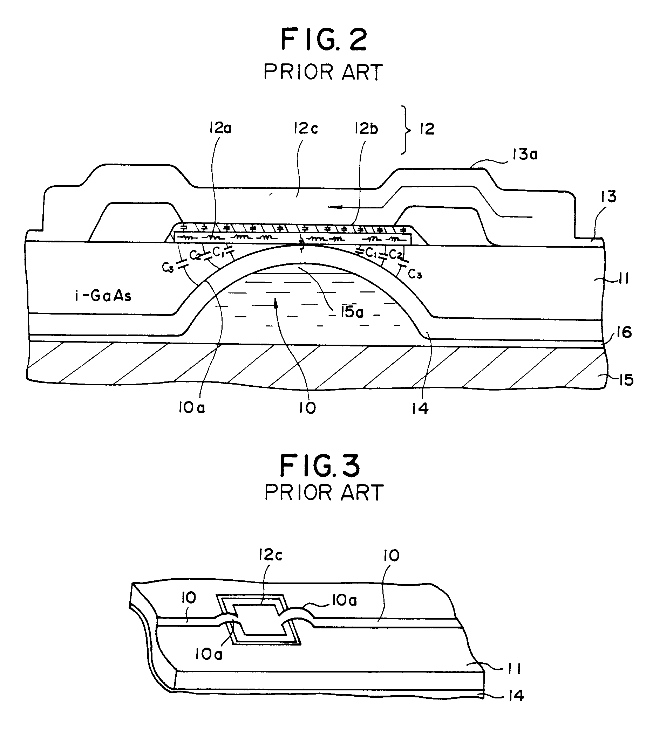

FIG.2 is a cross sectional view showing the structure of a prior art shunt capacitor. Referring to the drawing, the shunt capacitor comprises a semi-insulating substrate 11 of gallium arsenide, and an internal electrode 12a is provided on the substrate in correspondence to where the capacitor is to be formed. On the internal electrode 12a, there is further provided a dielectric film 12b and a surface electrode 12c is provided further thereon so as to make an electrical contact with the dielectric film 12b. This surface electrode 12c is connected to a transmission strip 13 forming the signal path. On a rear side of the substrate 11, it can be seen that there is formed a large through hole 10 in correspondence to the internal electrode 12a so as to expose a central part of the electrode 12a, and a ground electrode 14 is provided on the bottom of the substrate 11 including an inner surface 10a of the contact hole 10. Further, the ground electrode 14 is connected to a metal base 15 having a ground potential level via a brazing filler 16 and thus there is formed a shunt capacitor region having one electrode 12c connected to the transmission strip 13 and the other electrode 14 connected to the ground. Conventionally, the contact hole 10 is formed by removing a part of the substrate 11 corresponding to the contact hole 10 by isotropic etching. FIG.3 shows a connection of the shunt capacitor of FIG.2 to the MMIC shown in FIG.1. As can be seen in the drawing, the transmission strip 13 formed on the substrate 11 is connected to the surface electrode 12c via an airbridge structure 13a.

In such a prior art capacitor, there is a problem in that the shunt capacitor thus formed is mechanically fragile as the through hole 10 has a semi-circular vertical cross section which contacts tangentially with the internal electrode 12a and there is formed a thin central region in the substrate 11 in correspondence to a central part of the contact hole 10. When the substrate 11 is brazed on the metal base 15, for example, there usually remains a small amount of air at the top of the brazing filler 16 filling the contact hole 10 as designated by a space 15a. The air filling the space 15a reduces its volume upon cooling and as a result, the thin region at the central part of the contact hole 10 tends to be broken because of the air pressure acting on the central part of the contact hole 10.

In the prior art capacitor illustrated in FIG.1, there exists another problem in that one has to provide an unnecessarily large internal electrode 12a so as to tolerate variation of size of the contact hole 10, as the exact control of wet etching to form the contact hole 10 having an exact size is difficult in the presently available technique. Associated therewith, there are formed a number of parasitic paths between the internal electrode 12a and the bottom electrode 14 as illustrated in FIG.1 by parasitic capacitors C₁ - C₃ and as a result, there arises still another problem in that the electrical property of the shunt capacitor is deviated from the designed value. As the region of the substrate 11 corresponding to the central part of the contact hole 10 has a reduced thickness, the effect of these parasitic capacitors is not negligible. Because of the poor control of the size of the contact hole 10 as already described, it is not possible to design the shunt capacitor by taking the effect of these parasitic capacitors into consideration in advance.

Further, as a result of the excessive extension of the internal electrode 12a, a part of the high frequency signal component which has passed the dielectric film 12b from the surface electrode 12c to the internal electrode 12a is guided to the bottom electrode 14 by passing through the internal electrode 12a laterally. Thereby, the high frequency signal component experiences inductance formed by the internal electrode 12a.

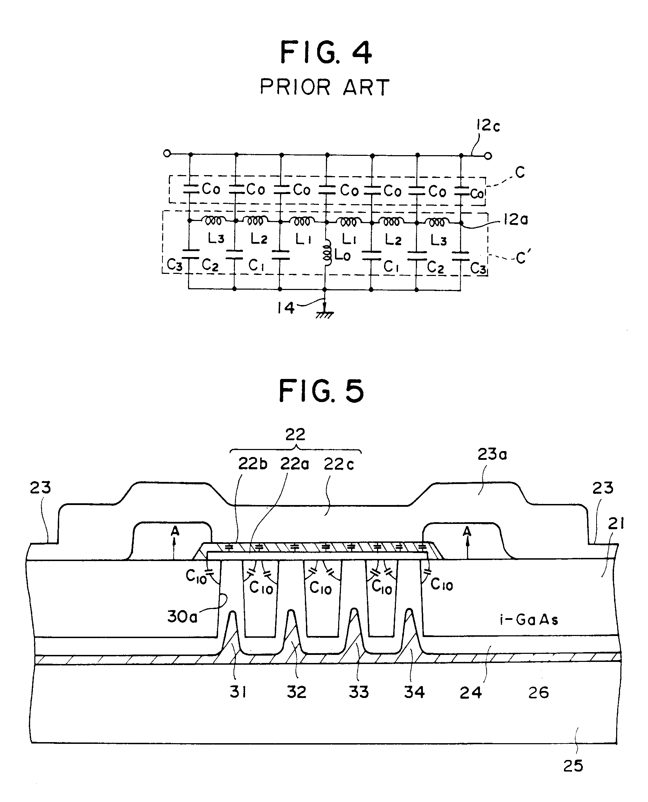

FIG.4 shows an equivalent circuit diagram of the shunt capacitor of FIG.2. In the drawing, the capacitance of the dielectric film 12b is represented by C₀ and the designed capacitance value C of the shunt capacitor 12 is given by a parallel connection of the capacitors C₀. Further, it can be seen that there appears parasitic inductances L₁ - L₃ extending laterally along the internal electrode 12a and each end of the inductances L₁ - L₃ is connected to the ground by the aforementioned parasitic capacitors C₁ - C₃. As a result, there is formed a parasitic circuit C′ comprising the parasitic inductances L₁ - L₃ and the parasitic capacitances C₁ - C₃ interposed between the capacitor 12 and the ground electrode 14. Note that the parasitic capacitors C₁ at the central region of the contact hole 10 has a capacitance which cannot be neglected because of the reduced thickness at the central region of the contact hole 10 while the capacitance of the capacitors C₂ and C₃ decreases its value towards the marginal region of the contact hole 10 because of the increased thickness of the substrate 11. Further, there is formed an additional parasitic inductance L₀ between the internal electrode 12a and the ground electrode 14 at the center of the contact hole 10. In one example, it was found that the parasitic inductances L₁ - L₃ are about ten times larger than the parasitic inductance L₀. In other words, the effect of the parasitic inductances L₁ - L₃ cannot be neglected. Thus, the impedance of the parasitic circuit C′ in FIG.3 is not negligible. To make the matter worse, the impedance of the parasitic circuit C′ is varied device by device.

PATENT ABSTRACTS OF JAPAN vol. 11, no. 11 (E-470)(2458) 13 January 1987, & JP-A-61 187278 (NEC CORP) 20 August 1986, shows a semiconductor device having a built-in capacitor where an upper electrode is formed on an insulating layer which in turn is formed on the top surface of a GaAs-substrate. The back electrode is formed on the bottom side of the substrate through a hole which extends to the insulating layer and which corresponds with the upper electrode.

### SUMMARY OF THE INVENTION

Accordingly, it is a general object of the present invention to provide a novel and useful semiconductor device having a built-in capacitor and a manufacturing method thereof.

Another and more specific object of the present invention is to provide a semiconductor device having a built-in capacitor and a manufacturing method thereof wherein the mechanical strength of the shunt capacitor is improved.

Another object of the present invention is to provide a semiconductor device having a built-in capacitor and a manufacturing method thereof wherein the effect of parasitic capacitance and inductance is reduced.

Another object of the present invention is to provide a semiconductor device having a built-in capacitor and a manufacturing method thereof wherein a desired capacitance is obtained with reliability.

Another object of the present invention is to provide a semiconductor device having a built-in capacitor exhibiting an excellent performance in the UHF and SHF frequency range.

Another object of the present invention is to provide a semiconductor device having a built-in capacitor comprising an internal electrode provided on a substrate, a dielectric film provided on the internal electrode and a surface electrode further provided on the dielectric film, wherein there are provided a plurality of contact holes by anisotropic etching so as to extend with substantially a same diameter from a bottom of the substrate to the internal electrode, and a ground electrode is provided on the bottom of the substrate so as to make contact with the internal electrode through the contact hole. According to the present invention, the contact holes have a side wall which extends substantially vertically to the substrate and the formation of parasitic capacitors between the internal electrode and the ground electrode at a part of the substrate where the thickness of the substrate is reduced is avoided. Further, as the contact holes are formed by a plurality of numbers, a high frequency signal component applied to the surface electrode is directly passed to the ground electrode via each of the contact holes without laterally travelling through the internal electrode. Thus, the effect of inductance experienced by the high frequency signal component is minimized. In other words, the effect of parasitic capacitance and inductance which causes unpredictable deviation of capacitance in the built-in capacitor in the prior art device is successfully eliminated by the present invention. Furthermore, the built-in capacitor thus formed has a satisfactory mechanical strength as there is formed no fragile thin region in the substrate in correspondence to the center of the contact holes. Note that the contact holes are formed by the anisotropic etching which provides a substantially vertical wall.

Other objects and further features of the present invention will become apparent from the following detailed description when read in conjunction with attached drawings.

### BRIEF DESCRIPTION OF THE DRAWINGS

FIG.1 is a block diagram showing a prior art MMIC device having a built-in capacitor;
FIG.2 is a cross sectional view showing a prior art shunt capacitor used in the device of FIG.1;
FIG.3 is a perspective view showing a connection of the capacitor of FIG.2 in the device of FIG.1;
FIG.4 is an equivalent circuit diagram of the shunt-capacitor of FIG.2;
FIG.5 is a cross sectional view showing a shunt capacitor according to an embodiment of the present invention;
FIG.6 is a plan view showing an array of contact holes used in the capacitor of FIG.5;
FIG.7 is an equivalent circuit diagram of the shunt capacitor of FIG.5; and
FIGS.8(A) - (D) are diagrams showing steps of forming the shunt capacitor of FIG.5.

### DETAILED DESCRIPTION

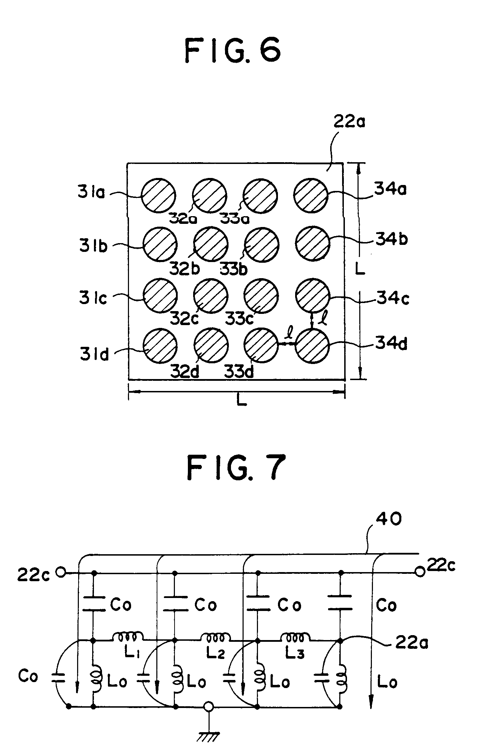

FIG.5 shows the structure of a shunt capacitor formed in a semiconductor device according to an embodiment of the present invention. Referring to the drawing, the shunt capacitor comprises a semi-insulating substrate 21 of gallium arsenide having a thickness of 50 - 100 µm, and an internal electrode 22a is provided on the substrate in correspondence to where the capacitor is to be formed. On the internal electrode 22a, there is further provided a dielectric film 22b and a surface electrode 22c is provided further thereon so as to make an electrical contact with the dielectric film 22b. This surface electrode 22c may have a size of 150 µm X 150 µm, for example, and is connected to a transmission strip 23 forming the signal path by an airbridge structure 23a. On a rear side of the substrate 21, it can be seen that there is formed a plurality of through holes or contact holes 31 - 34 in correspondence to a part of the substrate 21 covered by the internal electrode 22a. Thereby, the internal electrode 22a is exposed at a plurality of locations in correspondence to the contact holes 31 -34 and a ground electrode 24 having a thickness of about 3 - 5 µm is provided on the bottom of the substrate 21 including an inner surface 20a of the contact holes 31 - 34. Further, the ground electrode 24 is fixed on a metal base 25 having a ground potential level and acting as a heat sink by a brazing filler 26 of gold-tin alloy and thus there is formed a shunt capacitor region 22 wherein one electrode 22c is connected to the transmission strip 23 and the other electrode 24 is connected to the ground.

FIG.6 shows the shunt capacitor region 22 in a plan view. Referring to the drawing, there are formed sixteen contact holes 31a - 31d, 32a - 32d, 33a - 33d and 34a - 34d with a substantially equal mutual separation l which is a shortest distance measured from an edge of a contact hole to an adjacent edge of an adjacent contact hole. In the present invention, it is preferred to set the separation l to 10 - 20 µm or less and the diameter of the contact holes is preferrably set also to 10 - 20 µm.

In the present invention, the contact holes 31a - 31d, 32a - 32d, 33a - 33d and 34a - 34d are formed by an anisotropic etching proceeding vertically to the substrate 21 and as a result, the side wall 30a of the contact hole thus formed becomes generally vertical to the substrate 21 or at least assumes a steep angle substantially larger than 45 degrees with respect to the substrate as illustrated in FIG.5. Because of the steep angle of the side wall 30a, parasitic capacitors C₁₀ formed between the internal electrode 22a and the ground electrode 24 takes a value which is insignificant or negligible. As a result, the capacitance of the shunt capacitor is not affected by the parasitic capacitor C₁₀. Further, because of the steep angle of the side wall 30a with respect to the substrate 21, there is no thin region formed in the substrate 21 in contrast to the prior art device and the mechanical stability of the obtained shunt capacitor is improved. Thus, even if there remains air between the ground electrode 24 and the brazing filler 26 at the time of brazing of the device on the metal base 25, the contraction of the air volume upon cooling does not cause destruction of the device because of the improved mechanical strength. Furthermore, because of the steep angle of the side wall 30a, the variation of the anisotropic etching forming the contact holes 31 - 34 does not cause significant variation in the diameter of the contact holes and the structure shown in FIG.6 is obtained with reliability. In other words, the hitherto needed excessively large size of the internal electrode as well as of the dielectric film thereon for tolerating the variation of the contact hole can be eliminated by forming the contact holes by the anisotropic etching.

Furthermore, as a result of the plural contact holes provided with a sufficiently small mutual separation, a high frequency signal applied to the surface electrode 23a is immediately grounded through these plurality of contact holes and as a result, there is achieved an advantage such that: a) the inductance formed between a pair of neighboring contact holes is small; and b) the high frequency signal is not affected by these inductances when it is bypassed to the ground even when there exists finite inductance between the contact holes.

FIG.7 is an equivalent circuit diagram of the shunt capacitor of the present invention. Referring to the drawing, a high frequency signal 40 is applied to the surface electrode 22c from the transmission line 23. This signal is then passed through the dielectric film 22b having the capacitance C₀ and is bypassed to the ground after passing through a small inductance L₀ formed between the internal electrode 22a and the ground electrode 24. The parasitic capacitance C₁₀ connected parallel to the inductance L₀ takes a very small value as already described and thus does not affect on the transfer characteristic of the shunt capacitor. Although there are formed lateral inductances L₁ - L₃ in the internal electrode 22a so as to connect a pair of the parallel inductances L₀ as illustrated in FIG.7, these inductances do not affect the transfer of the high frequency signal 40 as the contact holes 31 - 34 are provided with a sufficiently small mutual separation and the signal is bypassed to the ground without flowing through these inductances. Even when there are currents flowing through the internal electrode 22a laterally, the effect of these lateral inductances is small and the effect of the parasitic inductance is negligible.

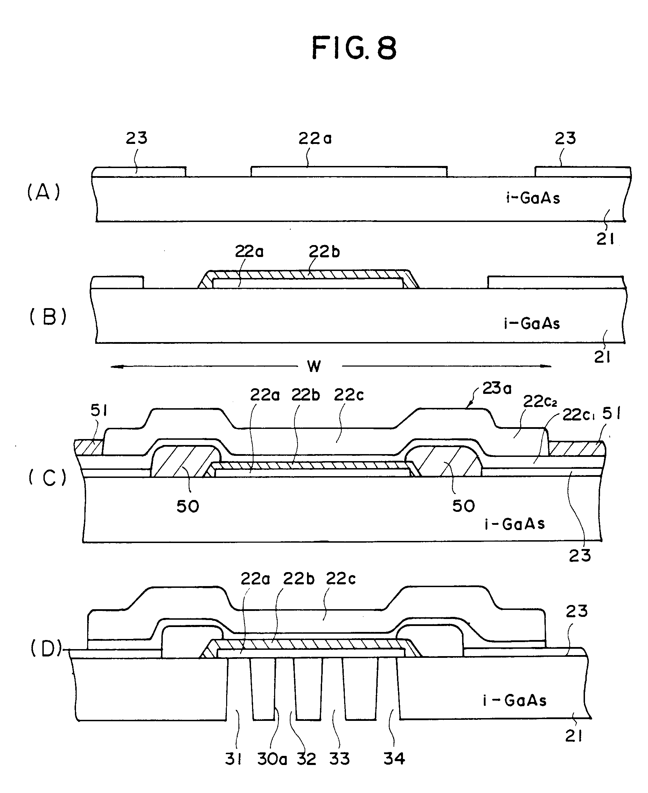

Next, manufacturing of the shunt capacitor of FIG.5 will be described with reference to FIGS.8(A) - (D). In a first step, a photoresist (not shown) is provided on the substrate 21 having a thickness of about 400 µm to 900 µm and after a suitable patterning, a part of the substrate 21 corresponding to the internal electrode 22a of the shunt capacitor 22 and another part of the substrate 21 corresponding to the transmission strip 23 are removed by etching. Further, the first part and the second part of the substrate 21 thus removed are successively deposited with titanium, platinum and gold by vacuum deposition and the internal electrode 22a and the transmission strip 23 are formed with an overall thickness of about 2000 Å. FIG.8(A) shows a structure thus obtained after the removal of the photomask. As already described, the internal electrode 22a is formed to have a size of 100 - 150 µm for each edge.

Next, the dielectric film 22b is formed by depositing silicon nitride by chemical vapor deposition or sputtering such that a layer of silicon nitride is formed with a thickness of about 1500 Å on the structure of FIG.8(A). Further, a part of the silicon nitride layer corresponding to the dielectric film 22b is protected by a photoresist and the rest of the silicon nitride layer is removed by dry etching using a fluoride etching gas. Thus, the dielectric film 22b is formed as illustrated in FIG.8(B).

Next, a photoresist is applied on the structure of FIG.8(B) and after a patterning to expose the dielectric film 22b and the transmission strip 23, a metal layer 22C₁ comprising stacking of a titanium layer and a gold layer is deposited on the entire surface of the structure thus formed. Note that there is formed a photoresist 50 in correspondence to the air bridge structure 23a on a pair of opposing edges of the dielectric film 22b, and the aforementioned metal layer 22C₁ is deposited on this photoresist 50. Next, the metal layer 22C₁ is selectively covered by a photoresist 51 so as to expose only a part W shown in FIG.8(C) and gold is plated on the metal layer 22C₁ selectively. As a result, a structure shown in FIG.3(C) is obtained wherein a thick gold layer 22C₂ is formed on the metal layer 22C₁ in correspondence to the part W.

Next, the photoresist 51 selectively covering the structure of FIG.8(C) is removed and a part of the gold layer in the layer 22C₁ not covered by the gold layer 22C₂ is removed by ion milling. Further, the titanium layer in the layer 22C₁ is removed by dry etching. Next, the photoresist 50 is removed by a suitable means such as dipping into a solvent and the surface electrode 22c is formed. Further, the back-side of the wafer is lapped to the required thickness (typically 50 to 100 µm).

Further, a photoresist (not shown) defining the contact holes 31 - 34 is deposited on the bottom of the substrate 21 and the bottom of the substrate 21 is subjected to the reactive ion etching (RIE) using a chloride etching gas. In one example, carbon dichloride difluoride (CCl₂F₂) was used as the etching gas and the RIE process was performed under a pressure of about 20 mTorr with an electrical power density of 0.4 W/cm². For this purpose, a direct-current voltage of 200 volts was applied across a pair of parallel electrodes of the etching apparatus (not shown). The etching was continued until the contact holes 31 - 34 reaches the internal electrode 22a. As the RIE process proceeds selectively in a vertical direction to the substrate 21, the obtained contact holes 31 - 34 have a steep or substantially vertical side wall extending directly to the internal electrode 22a. The diameter of the contact hole is usually set to about 10 - 20 µm. As a result, a structure shown in FIG.8(D) is obtained.

The structure of FIG.8(D) is then deposited with a nickel-chromium alloy (NiCr) by vacuum deposition on the bottom such that not only the bottom of the substrate 21 but also the bottom as well as the side wall of the contact holes 31 - 34 are covered uniformly with a thickness of about 1000 Å. Next, gold is plated on the nickel-chromium alloy layer with a thickness of about 3 - 5 µm and the contact electrode 24 is formed. The structure thus formed is then brazed on the metal base 25 by using a gold-tin alloy having a melting temperature of about 350 °C and the structure shown in FIG.5 is completed.

## Claims

1. A semiconductor device having a built-in capacitor (22), comprising a substrate (21), an internal electrode (22a) provided on a top side of said substrate, a dielectric film (22b) provided so as to cover said internal electrode (22a) for establishing a predetermined capacitance, and a surface electrode (22c) provided on said dielectric film so as to make a contact therewith, further comprising a plurality of through holes (31 - 34) formed in the substrate in correspondence to the internal electrode so as to extend from a bottom side to the top side, and a back-side electrode (24) provided on said bottom side of the substrate including the through holes so as to make a contact with the internal electrode through the through holes.

2. A semiconductor device as claimed in claim 1 characterized in that said through holes (31 - 34) are arranged in a row and column formation with a substantially uniform mutual separation.

3. A semiconductor device as claimed in claim 2 characterized in that said through holes (31 - 34) have a diameter of about 10 µm to about 20 µm and are separated from each other such that a shortest distance (l) connecting a rim of one of the through holes and a rim of a neighbouring through hole is about 20 µm or less.

4. A semiconductor device as claimed in claim 1 characterized in that said through holes (31 - 34) are defined by an inner wall (30a) forming a steep angle substantially larger than 45 degrees with respect to the substrate (21).

5. A semiconductor device as claimed in claim 1 characterized in that said through holes (31 - 34) are defined by an inner wall (30a) extending substantially vertically to the substrate (21).

6. A semiconductor device as claimed in claim 1 characterized in that the device further comprises a brazing filler (26) provided under the back-side electrode (24) such that the through hole (31 - 34) is substantially filled by the brazing filler and a metal base (25) provided further under the brazing filler.

7. A method of manufacturing a semiconductor device having a built-in capacitor (22) comprising steps of selectively depositing a conductor material on a top side of a substrate (21) to form an internal electrode (22a), depositing an insulating material on said internal electrode to form a dielectric film (22b) covering said internal electrode, and depositing a conductor material on said dielectric film to form a surface electrode (22c), further comprising steps of forming a plurality of through holes (31 -34) in the substrate in correspondence to the internal electrode by anisotropic etching on a bottom side of the substrate, and depositing a conductor material on said bottom side of the substrate including the through holes to form a back-side electrode (24).

8. A method as claimed in claim 7 characterized in that said anisotropic etching comprises a reactive ion etching acting vertically to the substrate (21).

9. A method as claimed in claim 8 characterized in that said reactive ion etching is performed by using carbon dichloride difluoride as an etching gas under a reduced pressure.

10. A method as claimed in claim 7 characterized in that said step of forming the back-side electrode (24) comprises a step of depositing a first conductor material by vacuum deposition to form a first conductor layer covering the bottom side of the substrate (21) and making a contact with the internal electrode through the through holes, and a step of plating a second conductor material on the first conductor layer.

11. A method as claimed in claim 10 characterized in that said first conductor material comprises a nickel-chromium alloy and said second conductor material comprises gold.

## Patentansprüche

1. Halbleitervorrichtung mit einem eingebauten Kondensator (22), beinhaltend
ein Substrat (21),
eine interne Elektrode (22a), die auf der Oberseite des Substrats angeordnet ist,
einen dielektrischen Film (22b), der so auf der Abdeckung der internen Elektrode (22a) angeordnet ist, daß er eine vorbestimmt Kapazität errichtet,
eine Oberflächenelektrode (22c), die so auf dem dielektrischen Film angeordnet ist, daß ein Kontakt mit ihm besteht, sowie weiter
eine Anzahl Durchgangslöcher (31-34), die in dem Substrat in Zuordnung zur internen Elektrode ausgebildet sind und von der Unterseite zur Oberseite gehen, sowie
eine Rückseitenelektrode (24), die auf der Unterseite des Substrats, das die Durchgangslöcher besitzt, angeordnet ist, so daß durch die Durchgangslöcher ein Kontakt mit der internen Elektrode besteht.

2. Halbleitervorrichtung nach Anspruch 1, dadurch gekennzeichtnet, daß die Durchgangslöcher (31-34) zueinander im wesentlichen gleichförmig beabstandet sind und zwar in einer Reihen- oder Säulenformation.

3. Halbleitervorrichtung nach Anspruch 2, dadurch gekennzeichnet, daß die Durchgangslöcher (31-34) einen Durchmesser von ca. 10 µm bis ca. 20 µm besitzen und voneinander so beabstandet sind, daß der kürzeste Abstand (1) zwischen dem Rand des einen Durchgangslochs und dem Rand des benachbarten Durchgangslochs ca. 20 µm oder weniger beträgt.

4. Halbleitervorrichtung nach Anspruch 1, dadurch gekennzeichnet, daß die Durchgangslöcher (31-34) definiert sind von einer Innenwand (30a), die gegenüber dem Substrat (21) einen steilen Winkel mit im wesentlichen mehr als 45° bildet.

5. Halbleitervorrichtung nach Anspruch 1, dadurch gekennzeichnet, daß die Durchgangslöcher (31-34) von einer Innenwand (30a), die im wesentlichen vertikal zum Substrat (21) verläuft, bestimmt sind.

6. Halbleitervorrichtung nach Anspruch 1, dadurch gekennzeichnet, daß die Vorrichtung weiter ein Lötfüllmaterial (26) aufweist, das unter der Rückseitenelektrode (24) so angeordnet ist, daß das Durchgangsloch (31-34) im wesentlichen von dem Lötfüllmaterial gefüllt ist und weiter unter dem Lötfülllmaterial ein Metallgrund (25) angeordnet ist.

7. Verfahren zur Herstellung einer Halbleitervorrichtung mit einem eingebauten Kondensator (22), umfassend
das selektive Abscheiden eines Leitermaterials auf der Oberseite eines Substrats (21), um eine interne Elektrode (22a) auszubilden;
das Ablagern eines Isoliermaterials auf der internen Elektrode, um einen dielektrischen Film (22b) auszubilden, der die interne Elektrode abdeckt; sowie
das Ablagern eines Leitermaterials auf dem dielektrischen Film, um eine Oberflächenelektrode (22c) auszubilden, und weiter
das Ausbilden einer Anzahl Durchgangslöcher (31-34) in dem Substrat in Zuordnung zur internen Elektrode durch anisotropes Ätzen auf einer Unterseite des Substrats; und
das Ablagern eines Leitermaterials auf der Unterseite des Substrats, das die Durchgangslöcher besitzt, so daß eine Rückseitenelektrode (24) ausgebildet wird.

8. Verfahren nach Anspruch 7, dadurch gekennzeichent, daß das anisotrope Ätzen ein Reaktiv-Ionenätzen umfaßt, das vertikal auf das Substrat (21) wirkt.

9. Verfahren nach Anspruch 8, dadurch gekennzeichnet, daß das Reaktiv-Ionenätzen mit Dichlordifluorkohlenstoff als Ätzgas unter reduziertem Druck erfolgt.

10. Verfahren nach Anspruch 7, dadurch gekennzeichnet, daß das Ausbilden der Rückseitenelektrode (24) das Ablagern eines ersten Leitermaterials durch Vakuumablagerung umfaßt, so daß eine erste Leiterschicht ausgebildet wird, die die Unterseite des Substrats (21) abdeckt und durch die Durchgangslöcher einen Kontakt mit der internen Elektrode herstellt, und
das Plattieren eines zweiten Leitermaterials auf der ersten Leiterschicht.

11. Verfahren nach Anspruch 10, dadurch gekennzeichnet, daß das erste Leitermaterial einen Nickel-Chrom-Legierung aufweist und das zweite Leitermaterial Gold.

## Revendications

1. Dispositif à semiconducteur possédant un condensateur incorporé (22), qui comprend un substrat (21), une électrode interne (22a) disposée sur le côté de dessus dudit substrat, une pellicule diélectrique (22b) disposée de façon à couvrir ladite électrode interne (22a) afin d'établir une capacité prédéterminée, et une électrode de surface (22c) disposée sur ladite pellicule diélectrique de manière à établir un contact avec cette dernière, comprenant en outre une pluralité de trous passants (31 à 34) formés dans le substrat en correspondance avec l'électrode interne de façon à s'étendre du côté de dessous jusqu'au côté de dessus, et une électrode de côté arrière (24) disposée sur ledit côté de dessous du substrat comportant les trous passants de manière à établir un contact avec l'électrode interne par l'intermédiaire des trous passants.

2. Dispositif à semiconducteur selon la revendication 1, caractérisé en ce que lesdits trous passants (31, 34) sont disposés suivant une formation de rangées et de colonnes présentant une séparation mutuelle sensiblement uniforme.

3. Dispositif à semiconducteur selon la revendication 2, caractérisé en ce que lesdits trous passants (31 à 34) ont un diamètre d'environ 10 µm à environ 20 µm et sont séparés les uns des autres de façon que la plus courte distance (1) reliant un bord de l'un des trous passants à un bord d'un trou passant voisin soit d'environ 20 µm ou moins.

4. Dispositif à semiconducteur selon la revendication 1, caractérisé en ce que lesdits trous passants (31 à 34) sont définis par une paroi interne (30a) formant un angle escarpé sensiblement supérieur à 45° par rapport au substrat (21).

5. Dispositif à semiconducteur selon la revendication 1, caractérisé en ce que lesdits trous passant (31 à 34) sont définis par une paroi interne (30a) orientée sensiblement perpendiculairement par rapport au substrat (21).

6. Dispositif à semiconducteur selon la revendication 1, caractérisé en ce qu'il comprend en outre une substance d'apport de brasage (26) disposée sous l'électrode de côté arrière (24) de façon que le trou passant (31 à 34) soit sensiblement rempli par la substance d'apport de brasage et une base métallique (25) disposée en outre sous la substance d'apport de brasage.

7. Procédé de fabrication d'un dispositif à semiconducteur possédant un condensateur incorporé (22), qui comprend les opérations consistant à faire sélectivement déposer un matériau conducteur sur le côté de dessus d'un substrat (21) afin de former une électrode interne (22a), déposer un matériau isolant sur ladite électrode interne afin de former une pellicule diélectrique (22b) couvrant ladite électrode interne, et déposer un matériau conducteur sur ladite pellicule diélectrique afin de former une électrode de surface (22c), comprenant en outre les opérations consistant à former une pluralité de trous passants (31 à 34) dans le substrat en correspondance avec l'électrode interne par une gravure anisotrope sur le côté de dessous du substrat, et à faire déposer un matériau conducteur sur ledit côté de dessous du substrat comportant les trous passants afin de former une électrode de côté arrière (24).

8. Procédé selon la revendication 7, caractérisé en ce que ladite gravure anisotrope comprend une gravure par ions réactifs qui agit perpendiculairement au substrat (21).

9. Procédé selon la revendication 8, caractérisé en ce qu'on effectue ladite gravure par ions réactifs en utilisant du dichlorodifluorure de carbone comme gaz de gravure sous une pression réduite.

10. Procédé selon la revendication 7, caractérisé en ce que ladite opération de formation de l'électrode de côté arrière (24) comprend l'opération consistant à faire déposer un premier matériau conducteur par dépôt sous vide afin de former une première couche de conducteur couvrant le côté de dessous du substrat (21) et établissant un contact avec l'électrode interne via les trous passants, et l'opération consistant à plaquer un deuxième matériau conducteur sur la première couche de conducteur.

11. Procédé selon la revendication 10, caractérisé en ce que ledit premier matériau conducteur comprend un alliage nickel-chrome et ledit deuxième matériau conducteur comprend l'or.
